# EUROPÄISCHE PATENTSCHRIFT

(11) **EP 2 929 576 B1**
(45) Veröffentlichungstag und Bekanntmachung des Hinweises auf die Patenterteilung: **03.03.2021**
(21) Anmeldenummer: 13792590.5
(22) Anmeldetag: 07.11.2013
(51) Int. Cl.: H01L 51/52

(54) **ELEKTRONISCHE VORRICHTUNG MIT SAUERSTOFFIONENPUMPE**
ELECTRONIC DEVICE WITH OXYGEN ION PUMP
DISPOSITIF ÉLECTRONIQUE AVEC POMPE À OXYGÈNE IONISÉ

(30) Priorität: 05.12.2012 EP 12008149
(43) Veröffentlichungstag der Anmeldung: 14.10.2015
(73) Patentinhaber: Merck Patent GmbH, 64293 Darmstadt (DE)
(72) Erfinder: KUNTZ, Matthias, 64342 Seeheim-Jugenheim (DE); PAN, Junyou, 60320 Frankfurt am Main (DE); HILARIUS, Volker, 64823 Gross-Umstadt (DE)
(86) Internationale Anmeldenummer: PCT/EP2013/003360
(87) Internationale Veröffentlichungsnummer: WO 2014/086454

(56) Entgegenhaltungen:
- EP-A1- 1 267 385
- US-A- 6 083 459
- US-A1- 2008 035 492
- US-A1- 2008 106 191
- GARCIA-BARRIOCANAL J ET AL: "Colossal Ionic Conductivity at Interfaces of Epitaxial ZrO2:Y2O3/SrTiO3 Heterostructures", SCIENCE, AMERICAN ASSOCIATION FOR THE ADVANCEMENT OF SCIENCE, US, Bd. 321, 1. August 2008 (2008-08-01), Seiten 676-680, XP007913642, ISSN: 0036-8075, DOI: 10.1126/SCIENCE.1156393 in der Anmeldung erwähnt

## Beschreibung

Die vorliegende Erfindung betrifft eine elektronische Vorrichtung, die ein elektronisch-aktives Material und eine Sauerstoffionenpumpe zum Entfernen von Sauerstoff aus der Vorrichtung enthält. Des Weiteren betrifft die vorliegende Erfindung auch die Verwendung einer Sauerstoffionenpumpe zum Entfernen von Sauerstoff aus einer elektronischen Vorrichtung.

Es gibt heutzutage viele verschiedene elektronisch-aktive Materialien, die geeignet sind, um beispielsweise Leuchtmittel, Anzeigevorrichtungen, Solarzellen oder Feld-Effekt-Transistoren herzustellen. Diese Materialien werden insbesondere in sogenannten organischen Licht-emittierenden Dioden und in organischen Solarzellen eingesetzt. Viele dieser elektronisch-aktiven Materialien weisen jedoch den Nachteil auf, dass sie empfindlich gegenüber dem Umgebungsklima sind, insbesondere gegenüber Sauerstoff, Wasserdampf, Wasser und Ozon. Deswegen ist es notwendig, solche Materialien in elektronischen Vorrichtungen ausreichend zu versiegeln.

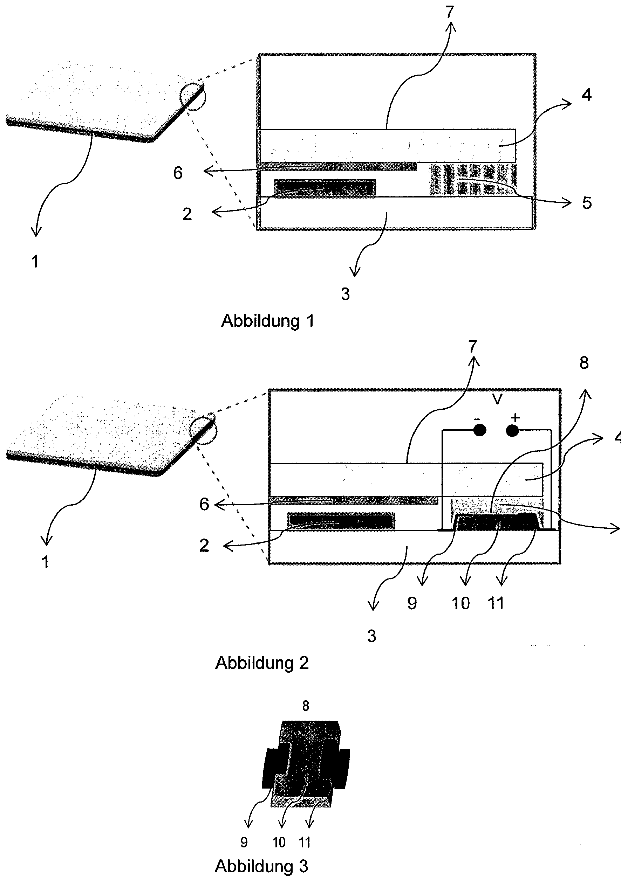

So werden beispielsweise bei einer Anzeigevorrichtung auf Basis von organischen Licht-emittierenden Dioden organische Verbindungen zwischen Glasplatten eingebettet, die am Rand versiegelt werden. Hierzu kommen gewöhnlich organische Kleber zum Einsatz, die jedoch eine Diffusion von Sauerstoff nicht vollständig unterbinden können. Somit kommt es bei fortschreitender Betriebsdauer zur langsamen Degenerierung der organischen Verbindungen und zu einem Verblassen der Farben in solchen Anzeigevorrichtungen. Abbildung 1 zeigt schematisch eine solche elektronische Vorrichtung. Im Stand der Technik werden zur Adsorption sogenannte Opfermaterialien (Gatter) innerhalb der Versiegelung angebracht, die den eindringenden Sauerstoff abfangen sollen. Eine weitere Möglichkeit zur Verhinderung des Eindringens von Sauerstoff ist die Versiegelung mit Glaslot. Speziell die zweite Variante ist problematisch, da zur Versiegelung mit Glaslot hohe Temperaturen notwendig sind und viele elektronisch-aktive Materialien, insbesondere organische elektronische Materialien nur eine begrenzte Temperaturstabilität aufweisen.

Die US 2008/0035492 A1 offenbart eine Elektrolytanordnung auf Metalloxidbasis zur Verwendung als Dünnschicht-Sauerstofftrennvorrichtung, insbesondere in Verbindung mit flexiblen Polymersubstratmaterialien.

Dem Umstand des Verhinderns des Eindringens von Sauerstoff in eine solche elektronische Vorrichtung kommt deshalb enorme Bedeutung zu, da Kunststoffe, mit denen die Zellen versiegelt werden, nicht dicht gegen Sauerstoffdiffusion sind. Verwendet man statt Glasplatten - so wie es in der Zukunft voraussichtlich eine immer größere Rolle spielen wird - transparente Polymerfolien, so sind diese ebenfalls nicht dicht gegen Sauerstoffdiffusion. In jedem der angesprochenen Fälle wird der eindringende Sauerstoff die Funktionsfähigkeit des elektronisch-aktiven Materials nach und nach zunichtemachen. Dies äußert sich insbesondere darin, dass beispielsweise in Anzeigevorrichtungen die Farben nach und nach verblassen. Zwar kann dem teilweise mit einer intelligenten Elektronik entgegengesteuert werden, dennoch ist es wünschenswert, dass es nicht zu dieser Schädigung kommt.

Es war deshalb die Aufgabe der vorliegenden Erfindung, eine elektronische Vorrichtung bereitzustellen, bei der nach und nach eindringender Sauerstoff konstant wieder aus der Vorrichtung entfernt werden kann, so dass die Lebensdauer solcher Vorrichtungen erhöht wird.

Die Aufgabe der vorliegenden Erfindung wird durch das Bereitstellen einer elektronischen Vorrichtung gelöst, die mindestens ein elektronisch-aktives Material, eine Umhüllung, die das elektronisch-aktive Material in ihrem Inneren einschließt, und eine Sauerstoffionenpumpe enthält, wobei die Sauerstoffionenpumpe entweder ein integraler Bestandteil der Umhüllung ist oder an der inneren Oberfläche der Umhüllung angebracht ist, und wobei die Sauerstoffionenpumpe an zwei entgegengesetzten Enden eines Sauerstoffionen-leitenden Materials eine Kathode und eine Anode enthält, wobei zumindest ein Teil der Kathode zu dem Inneren der Umhüllung hin und zumindest ein Teil der Anode zum Äußeren der Umhüllung hin gerichtet ist und wobei die Umhüllung ein Substrat, eine Verschlusskappe und einen Klebstoff umfasst, wobei der Klebstoff das Substrat und die Verschlusskappe miteinander versiegelt, dadurch gekennzeichnet, dass die Sauerstoffionenpumpe im Bereich des Klebstoffs angeordnet ist.

Unter dem Ausdruck "zumindest ein Teil der Kathode zu dem Inneren der Umhüllung hin gerichtet" soll verstanden werden, dass die Kathode sich zumindest teilweise im Innenraum der Umhüllung befindet, d.h. dem Raum der durch die Umhüllung begrenzt wird. Unter dem Ausdruck "zumindest ein Teil der Anode zum Äußeren der Umhüllung hin gerichtet" soll verstanden werden, dass die Anode sich auf dem zum Inneren der Umhüllung hin entgegenstehenden Raum, vorzugsweise der Raum außerhalb der Umhüllung, befindet, d.h. die Anode befindet sich weiter von dem Zentrum der Umhüllung als die Kathode entfernt. Nur auf diese Weise kann gewährleistet werden, dass bei Anlegen einer Spannung an Anode und Kathode durch das dazwischenliegende Sauerstoffionen-leitende Material Sauerstoff aus dem Inneren der Umhüllung nach aussen transportiert werden.

Eine solche erfindungsgemäße Ausführungsform ist in der Abbildung 2 der vorliegenden Anmeldung gezeigt.

In einer weiteren Ausführungsform der erfindungsgemäßen elektronischen Vorrichtung ist es insbesondere bevorzugt, dass das Sauerstoffionen-leitende Material an der Seite der Kathode Kontakt mit dem Innenraum der Umhüllung hat und mit der der Anode zugewandten Seite Kontakt mit der äußeren Umgebung der Umhüllung aufweist, wobei die Sauerstoffionenpumpe vorzugsweise in den Klebstoff eingebettet ist. Eine solche Ausführungsform kann beispielsweise auch der Abbildung 2 entnommen werden. Sauerstoffionenpumpen, die in den Klebstoffbereich einer erfindungsgemäßen Vorrichtung integriert werden können, werden beispielhaft in der Abbildung 3 gezeigt.

In einer weiteren Ausführungsform der erfindungsgemäßen elektronischen Vorrichtung ist es bevorzugt, dass die Sauerstoffionenpumpe als Schicht zumindest bereichsweise auf dem Substrat und/oder der Verschlusskappe angeordnet ist. "zumindest bereichsweise" bedeutet, dass wenigstens ein Teil der Oberfläche des Substrats und/oder der Verschlusskappe mit vorzugsweise einer Schicht der Sauerstoffionenpumpe versehen ist. Alternativ kann aber auch die gesamte Oberfläche des Substrats und/oder der Verschlusskappe mit einer Schicht der Sauerstoffionenpumpe versehen werden.

Unter einer Schicht der Sauerstoffionenpumpe versteht man eine Schicht, die aus mindestens drei Unterschichten aufgebaut ist, wobei eine der Unterschichten eine Schicht der Kathode, eine weitere der Unterschichten eine Schicht der Anode und eine noch weitere der Unterschichten die Schicht des Sauerstoffionen-transportierenden Materials darstellt. Auch hier befindet sich die Sauerstoffionen-leitende Schicht zwischen den Schichten der Anode und der Kathode. In dieser Ausführungsform befindet sich die Kathode vorzugsweise an der inneren Oberfläche der Umhüllung, das heißt des Substrats und/oder der Verschlusskappe und die Kathode ist zum Innenraum der Umhüllung orientiert.

Ganz allgemein versteht man in dieser Anmeldung unter dem "Inneren der Umhüllung" den Innenraum der erfindungsgemäßen elektronischen Vorrichtung, der von der Umhüllung eingeschlossen wird. Unter dem Begriff "Äußeres der Umhüllung" versteht man in dieser Anmeldung allgemein den Raum außerhalb der Umhüllung, der nicht von dieser eingeschlossen wird.

In der Ausführungsform der vorliegenden Erfindung, in der die Sauerstoffionenpumpe als Schicht zumindest bereichsweise auf dem Substrat und/oder der Verschlusskappe angeordnet ist, ist es bevorzugt, dass zumindest ein Bereich des Substrats und/oder der Verschlusskappe, auf dem die Sauerstoffionenpumpe angebracht ist, zum Äußeren der Umhüllung hin Sauerstoff-durchlässig ist. Dies kann beispielsweise dadurch gewährleistet werden, dass ein Sauerstoff-durchlässiges Material, wie beispielsweise eine Polymerschicht als Umhüllung verwendet wird, oder dadurch, dass das Material der Umhüllung Aussparungen aufweist.

Das Substrat besteht in der vorliegenden Anmeldung vorzugsweise aus Glas, Keramik, Metall, einer Polymerschicht oder eine Plastikschicht, wobei ein flexibles Substrate bevorzugt ist. In einer bevorzugten Ausführungsform besteht das flexible Substrate aus Polymer oder Plastik. Die wichtigsten Auswahlkriterien für Polymere oder Kunststoffe sind 1) hygienische Aspekte und 2) Glasübergangstemperatur. Die Glasübergangstemperatur (Tg) der Polymere kann bekannten Handbüchern entnommen werden (z.B. "Polymer Handbook", Eds. J. Brandrup, EH Immergut und EA Grulke, John Willey & Sons, Inc., 1999, VI/193-VI/276). Vorzugsweise ist Tg des Polymers oberhalb von 100°C, ganz bevorzugt oberhalb 150°C und ganz besonders bevorzugt oberhalb von 180°C. Sehr bevorzugte Substrate sind beispielsweise Poly (ethylenterephthalat) (PET) und Poly (ethylen 2,6-naphthalat) (PEN).

Die Verschlusskappe besteht in der vorliegenden Anmeldung vorzugsweise aus Glas, Keramik, Metall, einer Polymerschicht oder einer Plastikschicht. Glas und Metall sind insbesondere bevorzugt.

Eine als Substrat oder Verschlusskappe verwendete Keramik kann eine der folgenden sein: Silikatglas, Carbide (SiC), Metalloxide (Al₂O₃), Nitride (Si₃N₄) und andere nicht-Silikatgläser

In der vorliegenden Erfindung ist das Sauerstoffionen-leitende Material vorzugsweise ein Festkörperelektrolyt. Der erfindungsgemäß zu verwendende Festkörperelektrolyt ist in der Lage, an der Kathode aus Sauerstoff gebildete O²⁻-Ionen zu transportieren, die an der entgegengesetzten Seite zur Kathode, d.h. an der Anode von dieser wieder zu Sauerstoff umgewandelt werden. Im Prinzip kann ein Festkörperelektrolyt, der typischerweise in Festoxidbrennstoffzellen verwendet werden kann, auch in erfindungsgemäßen Vorrichtungen verwendet werden. Geeignete Materialen für Festkörperelektrolyte sind beispieleweise Zirkoniumdioxid, Bismuthoxid, Thoriumoxid, Hafniumoxid, Apatite, Ceriumoxid, Lanthan Molybdate, Lanthanoid Oxyfluoride, Lanthanoxide sowie Kombinationen davon. In einer Ausführungsform ist die Festkörperelektrolyt dotiert oder stabilisiert durch vorzugsweise Metalle der Seltenen Erden oder Lanthanoide. Übersichten von Festkörperelektrolyt findet man zum Beispiele in Adachi et al., Chem. Rev. 2002, 102, 2405-2429; Kendrick et al., Annu. Rep. Prog. Chem., Sect. A, 2009, 105, 436-459; Malavasi et al., Chem. Soc. Rev., 2010, 39, 4370-4387. Besonders bovorzugtes ist der Festkörperelektrolyt aus der Gruppe ausgewählt, die aus Yttrium-stabilisiertem Zirkonoxid, Ytterbium-stabilisiertem Zirkonoxid, Kalzium-stabilisiertem Zirkonoxid, Cerium-stabilisiertem Zirkonoxid, Ytterbium-stabilisiertem Zirkonoxid, Scandium-stabilisiertem Zirkonoxid, Titanoxid, Zinnoxid, Zinkoxid und Kombinationen davon besteht.

In einer sehr bevorzugtes Ausführungsform enthält die Sauerstoffionenpumpe eine Sauerstoffionen-leitende Schicht, die einen Mehrschichtenaufbau aufweis, wie zum Beispiele ein Superlattice, wie berichtet durch J. Garcia-Barriocanal, et al. in Science 321, 676 (2008).

Die Kathode der Sauerstoffionenpumpe, enthält vorzugsweise ein Material, die Sauerstoff Reduktionsreaktion katalysiert. Vorzugsweise besteht die Kathodemateriial aus Edelmetall besonders bevorzugte Pt, Pd. Die Kathode ist vorzugsweis gasdurchlässig, wie zum Beispiel in Form eines Metallgitters.

Die Anode der Sauerstoffionenpumpe ist vorzugsweise ein Material, das aus der Gruppe ausgewählt ist, die aus Metall, leitfähigem Metalloxid und leitfähigem Polymere besteht. Vorzugsweise besteht die Anode aus einem oder mehreren dieser Materialien.

Das elektronisch-aktive Material ist vorzugsweise ein Sauerstoffempfindliches Material. Unter einem Sauerstoff-empfindlichen Material versteht man, dass dieses durch die Anwesenheit von Sauerstoff irreversibel in seinen elektronischen Eigenschaften geschädigt wird. Das elektronisch-aktive Material kann ein organisches elektronisches Material oder ein Material sein, das zumindest einen Quantenpunkt enthält. Vorzugsweise ist das elektronisch-aktive Material jedoch ein organisches elektronisches Material.

Das organisch-elektronische Material kann ein Licht-emittierendes Material, ein Lochtransport-Material (HTM), ein Lochinjektions-Material (HIM), ein Elektronentransport-Material (ETM), ein Elektroneninjektions-Material (EIM), ein Loch-blockierendes Material (HBM), ein Elektronenblockierendes Material (EBM), ein Exzitonen-blockierendes Material (ExBM), ein Host-Material, ein organischer Metallkomplex, ein organischer Farbstoff oder eine Kombination davon sein.

Ein Licht-emittierendes Material ist ein Material, das vorzugsweise Licht im sichtbaren Bereich emittiert. Das Licht-emittierende Material weist vorzugsweise ein Emissionsmaximum zwischen 380 nm und 750 nm auf. Das Licht-emittierende Material ist vorzugsweise eine phosphoreszierende oder fluoreszierende Emitterverbindung.

Eine fluoreszierende Emitterverbindung im Sinne dieser Erfindung ist eine Verbindung, welche bei Raumtemperatur Lumineszenz aus einem angeregten Singulett-Zustand zeigt. Im Sinne dieser Erfindung sollen insbesondere alle lumineszierenden Verbindungen, welche keine Schweratome enthalten, also keine Atome mit der Ordnungszahl größer 36, als fluoreszierende Verbindungen angesehen werden.

Besonders bevorzugt werden als Licht-emittierende Materialien phosphoreszierende Emitterverbindungen eingesetzt. Unter einer phosphoreszierenden Emitterverbindung wird allgemein eine Verbindung verstanden, die Lumineszenz aus einem angeregten Zustand mit höherer Spinmultiplizität zeigt, also ein Spinzustand > 1, wie beispielsweise aus einem angeregten Triplett-Zustand (Triplett-Emitter), aus einem MLCT-Mischzustand oder einem Quintett-Zustand (Quintett-Emitter). Als phosphoreszierende Emitterverbindungen eignen sich insbesondere Verbindungen, die bei geeigneter Anregung Licht, vorzugsweise im sichtbaren Bereich, emittieren und außerdem mindestens ein Atom der Ordnungszahlen > 38 und < 84, besonders bevorzugt > 56 und < 80 enthalten. Bevorzugt werden als Phosphoreszenz-Emitter Verbindungen, die Kupfer, Molybdän, Wolfram, Rhenium, Ruthenium, Osmium, Rhodium, Iridium, Palladium, Platin, Silber, Gold oder Europium enthalten, insbesondere Verbindungen, die Iridium, Platin oder Kupfer enthalten. Beispiele der oben beschriebenen Emitter können den Anmeldungen WO 00/70655, WO 01/41512, WO 02/02714, WO 02/15645, EP 1191613, EP 1191612, EP 1191614, WO 2005/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind.

HTMs oder HIMs sind Materialien, die lochtransportierende oder lochinjizierende Eigenschaften aufweisen. Beispiele für solche Materialien sind: Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital). Vorzugsweise führen diese Arylamine und Heterocyclen zu einem HOMO im Polymer von mehr als -5,8 eV (gegen Vakuumlevel), besonders bevorzugt von mehr als -5,5 eV.

ETMs und EIMs sind Materialien, die Elektronen-transportierende oder Elektronen-injizierende Eigenschaften aufweisen. Beispiele für solche Materialien sind: Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital). Vorzugsweise führen diese Einheiten im Polymer zu einem LUMO von weniger als -2,5 eV (gegen Vakuumlevel), besonders bevorzugt von weniger als -2,7 eV.

HBMs sind Materialien, die die Bildung von Löchern blockieren bzw. deren Transport unterbinden. HBMs werden häufig bei Vorrichtungen mit phosphoreszierenden Emittern zwischen der lichtemittierenden Schicht und der Elektronentransportschicht eingefügt.

Als HBMs sind Metallkomplexe wie z.B. BAIQ (= Bis(2-methyl-8-chinolinolato)(4-phenylphenolato)aluminium(III)) geeignet. Irppz (Ir(ppz)₃ = *fac*-Tris(1-phenylpyrazolato-N,C²)iridium(III)) wird ebenfalls zu diesem Zweck verwendet. Phenanthrolin-Derivate wie z.B. BCP (= 2,9-dimethyl-4,7-diphenyl-1,10-phenanthrolin, = Bathocuproin) oder Phthalimide wie z.B. TMPP (= 2,3,5,6-Tetramethylphenyl-1,4-(bis-phthalimid)) werden ebenfalls vorteilhaft eingesetzt. Geeignete HBMs sind weiterhin beschrieben in WO 00/70655 A2, WO 01/41512 und WO 01/93642 A1. Geeignet sind weiterhin Triazinderivate, Spirooligophenylene und Ketone bzw. Phosphinoxide.

EBMs sind Materialien, die den Transport von Elektronen unterbinden bzw. blockieren. Ebenso sind ExBMs Materialien, die den Transport oder die Bildung von Excitonen unterbinden bzw. blockieren. Als EBMs und ExBMs werden Übergangsmetallkomplexe wie z.B. Ir(ppz)₃ (US 2003-0175553) und AlQ₃ vorteilhaft eingesetzt. Ebenso geeignet sind Arylamine, insbesondere Triarylamine (z.B. in US 2007-0134514 A1 beschrieben) und substituierte Triarylamine (z.B. MTDATA oder TDATA (= 4,4',4"-Tris(N,N-diphenylamino)triphenylamin)), N-substituierte Carbazolverbindungen (z.B. TCTA), Heterozyklen (z.B. BCP) oder Tetraazasilanderivate.

Ein Host-Material ist vorzugsweise ein Material, das als Matrix für eine Licht-emittierende Verbindung eingesetzt wird. Als Hostmaterialien für fluoreszierende Emitter kommen Materialien verschiedener Stoffklassen in Frage. Bevorzugte Host-Materialien sind ausgewählt aus den Klassen der Oligoarylene (z. B. 2,2',7,7'-Tetraphenylspirobifluoren oder Dinaphthylanthracen), insbesondere der Oligoarylene enthaltend kondensierte aromatische Gruppen wie z.B. Anthracen, Benzanthracen, Benzphenanthren, Phenanthren, Tetracen, Coronen, Chrysen, Fluoren, Spirofluoren, Perylen, Phthaloperylen, Naphthaloperylen, Decacyclen, Rubren, der Oligoarylenvinylene (z. B. DPVBi = 4,4'-Bis(2,2-diphenylethenyl)-1,1'-biphenyl) oder Spiro-DPVBi gemäß EP 676461), der polypodalen Metallkomplexe, insbesondere Metallkomplexe von 8-Hydroxychinolin, z.B. AlQ₃ (= Aluminium(III)tris(8-hydroxychinolin)) oder Bis(2-methyl-8-chinolinolato)-4-(phenylphenolinolato)aluminium, auch mit Imidazol-Chelat sowie der Chinolin-Metallkomplexe, Aminochinolin-Metallkomplexe, Benzochinolin-Metallkomplexe, der lochleitenden Verbindungen, der elektronenleitenden Verbindungen, insbesondere Ketone, Phosphinoxide, Sulfoxide, etc., der Atropisomere, der Boronsäurederivate oder der Benzanthracene.

Unter organischen Metall-Komplexen versteht Metall-Ligand-Koordinationsverbindungen, worin der Ligand eine organische Verbindung ist. Unter die Metall-Komplexe fallen erfindungsgemäß alle Verbindungen, die ein Fachmann auf diesem Gebiet in organischen elektronischen Vorrichtungen einsetzen kann.

Unter "Farbstoffen" versteht man Verbindungen, die einen begrenzten Teil des sichtbaren weißen Lichtes absorbieren und den nicht absorbierten Teil des weißen Lichtes reflektieren. Dabei wird die Komplementärfarbe des wahrgenommen Lichtes vom Farbstoff absorbiert. Die Farbabsorption basiert bei Farbstoffen meist auf vielen konjugierten Doppelbindungen und aromatischen Grundkörpern. Bei der Absorption werden die konjugierten Elektronen im Doppelbindungssystem auf einen höheren Energiezustand gehoben und das Farbstoffmolekül gibt die Energie durch Strahlung in einer anderen Wellenlänge (oder durch Wärmeabstrahlung) wieder ab.

Unter "Quantenpunkt" (QDs) versteht man in der vorliegenden Erfindung eine nanoskopische Struktur aus einem Halbleitermaterial, wie beispielsweise InGaAs, CdSi, ZnO oder auch GaInP/InP. Quantenpunkte sind dadurch gekennzeichnet, dass die Ladungsträger (Elektronen, Löcher) in einem Quantenpunkt in ihrer Beweglichkeit in allen drei Raumrichtungen soweit eingeschränkt sind, dass ihre Energie nicht mehr kontinuierliche, sondern nur noch diskrete Werte annehmen kann. Quantenpunkte verhalten sich also ähnlich wie Atome, jedoch kann ihre Form, Größe oder die Anzahl von Elektronen in ihnen beeinflusst werden. Typischerweise beträgt ihre eigene atomare Größenordnung etwa 10⁴ Atome.

Die QDs der vorliegenden Erfindung beziehen sich insbesonders auf Halbleiter-Nanokristalle Kolloidale, auch als kolloidale Quantenpunkte bekannt oder Nanodots oder Nanokristalle, die durch chemische Verfahren hergestellt werden.

Geeigneten Halbleitermaterialien, die in QDs integriert werden können, sind ausgewählt, aus den Elementen der Gruppe II-VI, wie CdSe, CdS, CdTe, ZnSe, ZnO, ZnS, ZnTe, HgS, HgSe, HgTe und Legierungen davon, wie z.B. CdZnSe; Gruppe III-V, wie InAs, InP, GaAs, GaP, InN, GaN, InSb, GaSb, AlP, AlAs, AlSb und Legierungen wie InAsP, CdSeTe, ZnCdSe, InGaAs, Gruppe IV-VI, wie PbSe, PbTe und PbS und Legierungen davon; Gruppe III-VI, wie InSe, InTe, InS, GaSe und Legierungen wie InGaSe, InSeS; Gruppe IV Halbleiter, wie Si und Ge Legierungen davon, und Kombinationen davon in Verbundstrukturen.

In einer besonders bevorzugten Ausführungsform umfasst die QDs gemäß der vorliegenden Erfindung halbleitenden Materialien, die ausgewählt sind aus Gruppe II-VI-Halbleiter, deren Legierungen und Kern / Schale-Strukturen von denen. In weiteren Ausführungsformen umfassen die QDs der Erfindung die Gruppe II-VI-Halbleiter CdSe, CdS, CdTe, ZnSe, ZnS, ZnTe, Legierungen davon, Kombinationen davon und Kern / Schale, Kern / mehrschaligen Schalen-Strukturen davon.

In der erfindungsgemäßen elektronischen Vorrichtung ist das organische elektronische Material vorzugsweise ein Licht-emittierendes Material.

Die in der elektronischen Vorrichtung verwendete Sauerstoffionenpumpe besteht auf dem Prinzip, dass bestimmte Materialien bei Anlegung einer Spannung in der Lage sind O²⁻ zu transportieren. Hierbei macht dich die vorliegende Erfindung insbesondere das umgekehrte Prinzip einer Lamda-Sonde (insbesondere Nernst-Sonde) zu Nutzen, bei der ein Sauerstoffionen-leitendes Material auf den unterschiedlichen Sauerstoffpartialdruck auf zwei gegenüberliegenden Seiten reagiert, an die jeweils eine Elektrode angebracht sind. Bei unterschiedlichen Partialdruck kann es zu einem Fluss von Sauerstoffionen durch das Material kommen, wobei eine Spannung an den Elektroden gemessen werden kann. In der vorliegenden Anmeldung wird durch Anlegung einer Spannung an Kathode und Anode das Material quasi gezwungen Sauerstoffionen in der gewünschten Richtung zu transportieren. Je nach Art des verwendeten Sauerstoffionen-leitenden Materials muss hierfür eine Spannung im Bereich von 2 V bis 35 V angelegt werden.

Eine weitere Ausführungsform der vorliegenden Erfindung betrifft die Verwendung einer Sauerstoffionenpumpe zum Entfernen von Sauerstoff aus einer erfindungsgemäßen elektronischen Vorrichtung. In anderen Worten betrifft die vorliegende Erfindung auch ein Verfahren zum Entfernen von Sauerstoff aus einer erfindungsgemäßen elektronischen Vorrichtung unter Verwendung einer Sauerstoffionenpumpe, wie es weiter oben ausgeführt ist.

Die erfindungsgemäße elektronische Vorrichtung oder die in der erfindungsgemäßen Verwendung angeführte elektronische Vorrichtung ist vorzugsweise aus der Gruppe ausgewählt, die aus organischen bzw. polymeren organischen Elektrolumineszens-Vorrichtungen (OLED, PLED), organischen Feld-Effekt-Transistoren (OFETs), organischen integrierten Schaltungen (OICs), organischen Dünnfilmtransistoren (OTFTs), organischen Licht-emittierenden Transistoren (OLETs), organischen Solarzellen (OSCs), organischen optischen Detektoren, organischen Laserdioden (O-Laser), organischen Feld-Quench-Devices (OFQDs), Lichtemittierenden elektrochemischen Zellen (LECs), "organic plasmon emitting devices" und organischen photovoltaischen (OPV) Elementen oder Vorrichtungen, und organischen Photorezeptoren (OPCs) besteht.

Die mit der vorliegenden Erfindung offengelegte Lehre zum technischen Handeln kann abstrahiert und mit anderen Beispielen kombiniert werden. Die Erfindung wird durch die nachfolgenden Beispiele und Abbildungen näher erläutert, ohne sie dadurch einschränken zu wollen.

Kurzbeschreibung der Abbildungen:
Abbildung 1: Die Abbildung 1 (nicht Teil dieser Erfindung) zeigt eine elektronische Vorrichtung (1), die im Inneren ihrer Umhüllung (7) ein elektronisch-aktives Material (2) enthält. An der Unterseite befindet sich das Substrat (3), das über den Klebstoff (5) mit der Verschlusskappe (4) verbunden ist. Der Getter (6) dient hierbei dazu, eindringenden Sauerstoff abzufangen.
Abbildung 2: Abbildung 2 zeigt eine erfindungsgemäße elektronische Vorrichtung (1), in der eine Sauerstoffionenpumpe (8) im Klebstoff (5) angeordnet ist. Der Klebstoff verbindet hierbei die Verschlusskappe (4) mit dem Substrat (3). Auf dem Substrat befindet sich ein elektronisch-aktives Element (2). Die Sauerstoffionenpumpe enthält zum Innenraum der Umhüllung (7) gerichtet die Kathode (9) und zum äußeren der Umhüllung hin gerichtet die Anode (11). Zwischen der Anode und der Kathode befindet sich das Sauerstoffionen-leitende Material (10). Optional kann die erfindungsgemäße elektronische Vorrichtung auch einen Getter (6) enthalten.
Abbildung 3: Abbildung 3 zeigt beispielhaft eine Sauerstoffionenpumpe, wie sie beispielsweise in eine elektronische Vorrichtung gemäß Abbildung 2 eingebaut werden kann. An den beiden entgegengesetzten Enden des Sauerstoffionen-leitenden Materials (10) befinden sich die Kathode (9) und die Anode (11).

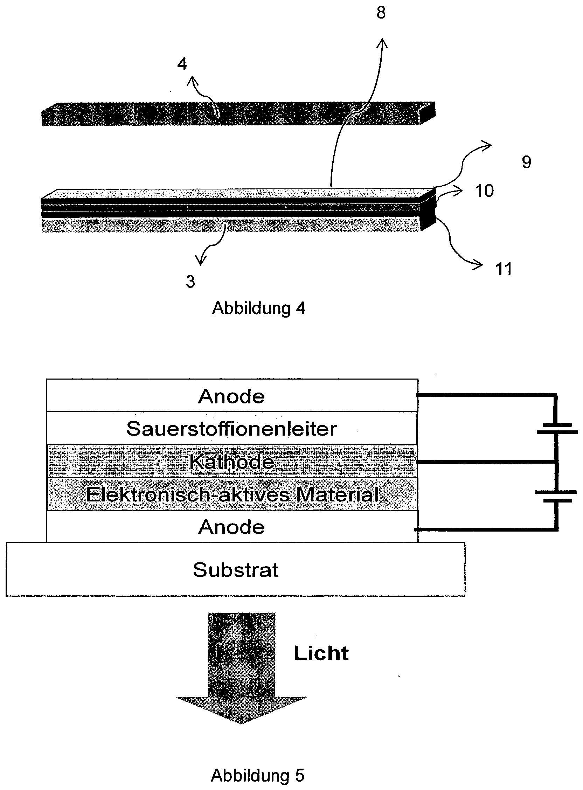

Abbildung 4: Abbildung 4 zeigt die schematische Ansicht der Anordnung einer Sauerstoffionenpumpe (8), die in einer elektronischen Vorrichtung als Schicht auf dem Substrat (3) eingebaut wurde. Die Anordnung der Verschlusskappe (4) soll festlegen, dass sich zwischen Verschlusskappe und Substrat der Innenraum der Umhüllung befindet. Somit befindet sich die Sauerstoffionenpumpe (8) auf der inneren Oberfläche des Substrats. Die Kathode (11) ist hierbei die erste Schicht auf dem Substrat, die Sauerstoffionen-leitende Schicht (10) die zweite Schicht und die Anode (9) die dritte, zum Innenraum hin gewandte Schicht.
Abbildung 5: Die Abbildung 5 zeigt eine mögliche Schichtanordnung im Inneren der Umhüllung auf einem Substrat, bei dem die Anode oberhalb der Sauerstoffionenpumpe an eine Sauerstoff-durchlässige Verschlusskappe anschließen soll. Das elektronisch-aktive Material ist hierbei vorzugsweise ein Lichtemittierendes Material, das bei Anlegen einer Spannung Licht emittiert. Das Substrat ist hier vorzugsweise ein Lichtdurchlässiges Substrat.

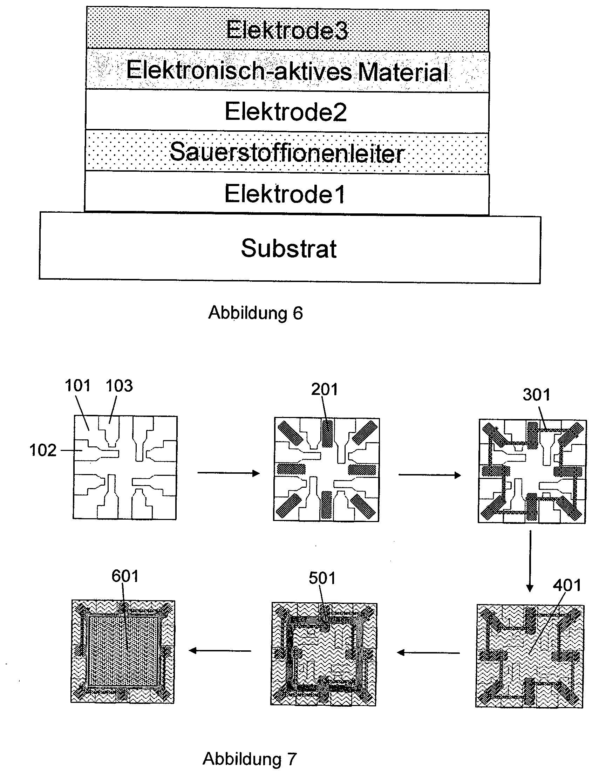

Abbildung 6: Abbildung 6 zeigt ebenso die mögliche Anordnung einer Sauerstoffionenpumpe in einer elektronischen Vorrichtung, wobei das elektrischen Potenzial von Elektrode2 niedriger als das von Elektrode1 ist und Sauerstoff an das vorzugsweise Sauerstoff-durchlässige Substrat abgeben soll. Das elektronisch-aktive Material ist vorzugsweise ein Lichtemittierendes Material, dass bei Anlegen einer Spannung Licht emittiert. Das Substrat ist vorzugsweise ein Lichtdurchlässiges Substrat.
Abbildung 7: Abbildung 7 zeigt ein Präparationsschema für eine elektronische Vorrichtung, wobei 101 ein Glassubstrat, 102 eine ITO Bank für den Anodenkontakt, 103 eine ITO Bank für den Kathodenkontakt, 201 eine 25 × [YSZ1nm/STO10nm] Superlattice Struktur auf 100 nm STO und 301 eine Pt Elektrode ist. 401 steht für den folgenden Schichtaufbau einer OLED: PEDOT/LEP/Ba/AI. 501 steht für UV-gehärtetes Harz und 601 für die Verkapselung mittels Glaskappe

### Beispiele

### Beispiel 1

### Herstellung eines Substrats mit Sauerstoffpumpe

Eine ITO-beschichtetes Glassubstrat, Sub1, (Technoprint Co. LTD.), mit einer Abmessung von 30×30 mm, wird in der vorliegenden Erfindung verwendet. Die Sub1 wird strukturiert, mit zwei ITO Banken, eine für Anodenkontakt (102) und einen anderen für Kathodenkontakt (103). Die Substrate werden zuerst im Reinraum mit deionisiertem (DI) Wasser und einem Detergens (Deconex 15 PF) gereinigt und dann durch eine UV/Ozon-Plasmabehandlung aktiviert.

Herstellung einer Sauerstoffpumpe enthaltend eine Superlattice Struktur ((201) in Abbildung 7): Zunächst wird eine 100 nm SrTiO₃ (STO) Schicht auf Sub1, und dann 8 mol% (Y₂O₃)ₓ (ZrO₂)₁₋ₓ (YSZ) und SrTiO₃ (STO) Schichten auf STO in einem Hochdruck (3 mbar) reinem Sauerstoff RF-Sputter-System mit Mask1 aufgebracht. Mask1 entspricht den 8 Bereichen (201). Hoher Druck und hohe Substrattemperatur (900 °C) ermöglichen ein langsames (1 nm/min) und hoch thermalisiertes Wachstum komplexer Oxide, was zu einer ausgezeichneten Filmqualität führt. Die Superlattices (201) mit 25 Wiederholungseinheiten von [YSZ₁ₙₘ/STO₁₀ₙₘ] werden aufgebracht.

Pt-Elektroden (301) in Form eines Gitters werden anschließend durch RF-Sputtern mit einer Shadow-Mask abgeschieden, um elektrischen Kontakt zwischen den Elektroden zu realisieren..

Das erhaltene Substrat wird als Sub2 bezeichnet, um die Vorrichtung gemäß der vorliegenden Erfindung herzustellen.

### Beispiel 2

### Herstellung von PLEDs

PLED1 mit dem Schichtaufbau Sub1/ITO/HIL/LEP/Kathode (Vergleich) und PLED2 mit dem Schichtaufbau Sub2/ITO/HIL/LEP/Kathode (erfindungsgemäß) werden nach dem folgenden Verfahren hergestellt, wobei ITO für eine Indium Zinn Anode, HIL für Lochinjektionsschicht und LEP für lichtemittierendes Polymer steht.
1) PEDOT (CLEVIOS™ P VP AI 4083) wird als HIL mit einer Dicke von 80 nm auf das Substrat durch Schleuderbeschichten aufgebracht und dann für 10 Minuten bei 180°C im Reinraum erhitzt;
2) Eine LEP (Light Emitting Polymer) Schicht von 65 nm wird durch Schleuderbeschichtung einer Lösung, SPB-02T (Merck KGaA) in Toluol mit einer Konzentration von 0,5 - 1 Gew.% in N₂-Glove-Box aufgebracht;
3) Die Vorrichtung wird bei 180°C für 10 Minuten in einer N₂-Glove-Box erhitzt;
4) Eine Ba/Al-Kathode wird durch Verdampfen auf die emittierende Schicht mit einer Dicke von 3 nm/150 nm im Vakuum von 10⁻⁶ Torr abgeschieden;
5) Die Vorrichtung wird in der N₂-Glove-Box versiegelt. Hierfür werden ein UV-härtenden Harz verwendet, UV Harz T-470/UR7114 (Nagase Chemtex Corporation) (501) in Abbildung 7, und einen Glasskappe (601) verwendet, wobei die Glasplatte kleiner ist als das Substrat, um die Kontakt-Pads unversiegelt zu halten (Abbildung 7). Das UV-Harz wird zunächst auf den Rand des Substrats angelegt. Die Kappe befindet sich dann auf der Oberseite. Dann wird die Vorrichtung für 30 Sekunden mit UV-Licht bestrahlt. Alle Schritte werden in einer Glove-Box durchgeführt.

### Beispiel 3

### Charakterisierung von PLED1 und PLED2

Die so erhaltenen PLED1 (Vergleich) und PLED2 (erfindungsgemäß) werden nach Standardmethoden charakterisiert. Dabei werden die folgenden Eigenschaften gemessen: UIL-Charakteristik, Elektrolumineszenzspektrum, Farbkoordinaten, Effizienz, Betriebsspannung und Lebensdauer. Die Ergebnisse sind in Tabelle 1 zusammengefasst, wobei PLED1 als Vergleich gemäß dem Stand der Technik dient. In Tabelle 1 steht Uₒₙ für die Einsatzspannung, und U(100) für die Spannung bei 100 cd/m². Die Lebensdauer wird bei konstanter Stromdichte mit spezifischer Anfangsleuchtdichte gemessen und wird als die Zeit definiert, bei der die anfängliche Luminneszenz auf die Hälfte abgefallen ist.

Für PLED2 wird während der Messung der Lebensdauern an den inneren Pt-Elektroden eine negativ Spannung und an den äußeren Pt-Elektroden eine positive Spannung angelegt, wobei die Spannung gleich gleich der Betriebsspannung der PLED ist, so dass O₂ in der Vorrichtung heraus gepumpt wird.

**Tabelle 1**

| | **Max. Eff. [Cd/A]** | **Uon [V]** | **U (100 cd/m²) [V]** | **CIE x** | **CIE y** | **Lifetime [hrs]** | **Initial Luminance [cd/m²]** |
|---|---|---|---|---|---|---|---|
| **PLED1** | **4.70** | **2.55** | **3.35** | **0.15** | **0.22** | **29** | **798** |
| **PLED2** | **4.86** | **2.57** | **3.34** | **0.16** | **0.22** | **49** | **830** |

Wie aus Tabelle 1 ersichtlich ist, zeigen die beiden PLEDs ganz ähnliche Eigenschaften, wobei PLED2 eine Lebensdauer aufweist, die fast 1.7-fach höher liegt, als die von PLED1.

Weitere Verbesserungen oder Optimierungen in den OLEDs können durch verschiedene Ansätze ohne erfinderisches Zutun erreicht werden. So können andere emittierende Materialien, andere Schichtaufbauten, etc. verwendet werden.

Die Anwendung der Sauerstoffpumpe, wie in der vorliegenden Erfindung beschrieben, kann auch ohne weiteres auf andere organische elektronische Vorrichtungen übertragen werden, beispielsweise auf OPV, OFET etc..

## Patentansprüche

1. Elektronische Vorrichtung (1), die mindestens ein elektronisch-aktives Material (2), eine Umhüllung (7), die das elektronisch-aktive Material (2) in ihrem Inneren einschließt, und eine Sauerstoffionenpumpe (8) enthält, wobei die Sauerstoffionenpumpe (8) entweder ein integraler Bestandteil der Umhüllung (7) ist oder an der inneren Oberfläche der Umhüllung (7) angebracht ist, und wobei die Sauerstoffionenpumpe (8) an zwei entgegengesetzten Enden eines Sauerstoffionen-leitenden Materials (10) eine Kathode (9) und eine Anode (11) enthält, wobei zumindest ein Teil der Kathode (9) zu dem Inneren der Umhüllung (7) hin und zumindest ein Teil der Anode (11) zum Äußeren der Umhüllung (7) hin gerichtet ist und wobei die Umhüllung (7) ein Substrat (3), eine Verschlusskappe (4) und einen Klebstoff (5) umfasst, wobei der Klebstoff (5) das Substrat (3) und die Verschlusskappe (4) miteinander versiegelt,
**dadurch gekennzeichnet, dass** die Sauerstoffionenpumpe (8) im Bereich des Klebstoffs (5) angeordnet ist.

2. Elektronische Vorrichtung gemäß Anspruch 1, worin die Sauerstoffionenpumpe (8) als Schicht zumindest bereichsweise auf dem Substrat (3) und/oder der Verschlusskappe (4) angeordnet ist.

3. Elektronische Vorrichtung gemäß Anspruch 2, worin der Bereich des Substrats (3) und/oder der Verschlusskappe (4), auf dem die Sauerstoffionenpumpe (8) angebracht ist, Sauerstoff-durchlässig ist.

4. Elektronische Vorrichtung gemäß Anspruch 1 oder 2, worin das Substrat (3) und/oder die Verschlusskappe (4) aus Glas, Keramik, einer Polymerschicht oder Plastik besteht.

5. Elektronische Vorrichtung gemäß einem oder mehreren der Ansprüche 1 bis 4, worin das Sauerstoffionen-leitende Material (10) ein Festkörperelektrolyt ist.

6. Elektronische Vorrichtung gemäß Anspruch 5, worin der Festkörperelektrolyt aus der Gruppe ausgewählt ist bestehend aus Yttrium-stabilisiertem Zirkonoxid, Ytterbium-stabilisiertem Zirkonoxid, Kalzium-stabilisiertem Zirkonoxid, Cerium-stabilisiertem Zirkonoxid, Ytterbium-stabilisiertem Zirkonoxid, Scandium-stabilisiertem Zirkonoxid, Titanoxid, Zinnoxid, Zinkoxid und Kombinationen davon.

7. Elektronische Vorrichtung gemäß einem oder mehreren der Ansprüche 1 bis 6, worin die Kathode (9) ein Material umfasst, das aus der Gruppe der Edelmetalle ausgewählt ist, bevorzugt Pt oder Pd, ganz bevorzugt liegt die Kathode (9) in Form eines gasdurchlässigen Metallgitters vor.

8. Elektronische Vorrichtung gemäß einem oder mehreren der Ansprüche 1 bis 7, worin das elektronisch-aktive Material (2) ein sauerstoffempfindliches Material ist.

9. Elektronische Vorrichtung gemäß einem oder mehreren der Ansprüche 1 bis 8, worin das elektronisch-aktive Material (2) ein organisches elektronisches Material oder ein zumindest einen Quantenpunkt enthaltendes Material ist.

10. Elektronische Vorrichtung gemäß Anspruch 9, worin das organische elektronische Material (2) ein Licht-emittierendes Material ist.

11. Verwendung einer Sauerstoffionenpumpe zum Entfernen von Sauerstoff aus einer elektronischen Vorrichtung gemäß einem oder mehreren der Ansprüche 1 bis 10.

12. Elektronische Vorrichtung gemäß einem oder mehreren der Ansprüche 1 bis 10 oder Verwendung nach Anspruch 11, worin die elektronische Vorrichtung ausgewählt ist aus der Gruppe bestehend aus organischen bzw. polymeren organischen Elektrolumineszenzvorrichtungen (OLED, PLED), organischen Feld-Effekt-Transistoren (OFETs), organischen integrierten Schaltungen (OICs), organischen Dünnfilmtransistoren (OTFTs), organischen lichtemittierenden Transistoren (OLETs), organischen Solarzellen (OSCs), organischen optischen Detektoren, organischen Laserdioden (O-Laser), organischen Feld-Quench-Devices (OFQDs), lichtemittierenden elektrochemischen Zellen (LECs), "organic plasmon emitting devices" und organischen photovoltaischen (OPV) Elementen oder Vorrichtungen, und organischen Photorezeptoren (OPCs).

## Claims

1. Electronic device (1) which comprises at least one electronically active material (2), a covering (7) which encloses the electronically active material (2) in its interior, and an oxygen ion pump (8), where the oxygen ion pump (8) is either an integral constituent of the covering (7) or is installed on the inside surface of the covering (7), and where the oxygen ion pump (8) comprises a cathode (9) and an anode (11) at two opposite ends of an oxygen ion-conducting material (10), where at least part of the cathode (9) is directed towards the inside of the covering (7) and at least part of the anode (11) is directed towards the outside of the covering (7) and where the covering (7) comprises a substrate (3), a sealing cap (4) and an adhesive (5), where the adhesive (5) seals the substrate (3) and the sealing cap (4) to one another, **characterised in that** the oxygen ion pump (8) is arranged in the region of the adhesive (5).

2. Electronic device according to Claim 1, in which the oxygen ion pump (8) is arranged as a layer at least in regions on the substrate (3) and/or the sealing cap (4).

3. Electronic device according to Claim 2, in which the region of the substrate (3) and/or of the sealing cap (4) on which the oxygen ion pump (8) is installed is oxygen-permeable.

4. Electronic device according to Claim 1 or 2, in which the substrate (3) and/or the sealing cap (4) consists of glass, ceramic, a polymer layer or plastic.

5. Electronic device according to one or more of Claims 1 to 4, in which the oxygen ion-conducting material (10) is a solid-state electrolyte.

6. Electronic device according to Claim 5, in which the solid-state electrolyte is selected from the group consisting of yttrium-stabilised zirconium oxide, ytterbium-stabilised zirconium oxide, calcium-stabilised zirconium oxide, cerium-stabilised zirconium oxide, ytterbium-stabilised zirconium oxide, scandium-stabilised zirconium oxide, titanium oxide, tin oxide, zinc oxide and combinations thereof.

7. Electronic device according to one or more of Claims 1 to 6, in which the cathode (9) comprises a material which is selected from the group of the noble metals, preferably Pt or Pd, very preferably the cathode (9) is in the form of a gas-permeable metal mesh.

8. Electronic device according to one or more of Claims 1 to 7, in which the electronically active material (2) is an oxygen-sensitive material.

9. Electronic device according to one or more of Claims 1 to 8, in which the electronically active material (2) is an organic electronic material or a material containing at least one quantum dot.

10. Electronic device according to Claim 9, in which the organic electronic material (2) is a light-emitting material.

11. Use of an oxygen ion pump (8) for the removal of oxygen from an electronic device according to one or more of Claims 1 to 10.

12. Electronic device according to one or more of Claims 1 to 10 or use according to Claim 11, in which the electronic device is selected from the group consisting of organic or polymeric organic electroluminescent devices (OLEDs, PLEDs), organic field-effect transistors (OFETs), organic integrated circuits (OICs), organic thin-film transistors (OTFTs), organic light-emitting transistors (OLETs), organic solar cells (OSCs), organic optical detectors, organic laser diodes (O-lasers), organic field-quench devices (OFQDs), light-emitting electrochemical cells (LECs), organic plasmon emitting devices and organic photovoltaic (OPV) elements or devices, and organic photoreceptors (OPCs).

## Revendications

1. Dispositif électronique (1), lequel comprend au moins un matériau électroniquement actif (2), un recouvrement (7) qui renferme le matériau électroniquement actif (2) à l'intérieur de lui-même, et une pompe à ions d'oxygène (8), dans lequel la pompe à ions d'oxygène (8) soit est un constituant d'un seul tenant du recouvrement (7) soit est installée sur la surface intérieure du recouvrement (7), et dans lequel la pompe à ions d'oxygène (8) comprend une cathode (9) et une anode (11) au niveau de deux extrémités opposées d'un matériau conducteur d'ions d'oxygène (10), dans lequel au moins une partie de la cathode (9) est orientée en direction de l'intérieur du recouvrement (7) et au moins une partie de l'anode (11) est orientée en direction de l'extérieur du recouvrement (7) et dans lequel le recouvrement (7) comprend un substrat (3), un capuchon d'obturation et d'étanchéité (4) et un adhésif (5), dans lequel l'adhésif (5) réalise l'obturation et l'étanchéité du substrat (3) et du capuchon d'étanchéité (4) l'un par rapport à l'autre, **caractérisé en ce que** la pompe à ions d'oxygène (8) est agencée dans la région de l'adhésif (5).

2. Dispositif électronique selon la revendication 1, dans lequel la pompe à ions d'oxygène (8) est agencée en tant que couche au moins dans des régions sur le substrat (3) et/ou sur le capuchon d'étanchéité (4).

3. Dispositif électronique selon la revendication 2, dans lequel la région du substrat et/ou du capuchon d'étanchéité (4) sur laquelle la pompe à ions d'oxygène (8) est installée est perméable à l'oxygène.

4. Dispositif électronique selon la revendication 1 ou 2, dans lequel le substrat (3) et/ou le capuchon d'étanchéité (4) sont/est constitué(s) par du verre, par de la céramique, par une couche en polymère ou par une matière plastique.

5. Dispositif électronique selon une ou plusieurs des revendications 1 à 4, dans lequel le matériau conducteur d'ions d'oxygène (10) est un électrolyte à l'état solide.

6. Dispositif électronique selon la revendication 5, dans lequel l'électrolyte à l'état solide est sélectionné parmi le groupe qui est constitué par l'oxyde de zirconium stabilisé par yttrium, l'oxyde de zirconium stabilisé par ytterbium, l'oxyde de zirconium stabilisé par calcium, l'oxyde de zirconium stabilisé par cérium, l'oxyde de zirconium stabilisé par ytterbium, l'oxyde de zirconium stabilisé par scandium, l'oxyde de titane, l'oxyde d'étain, l'oxyde de zinc et des combinaisons de ceux-ci.

7. Dispositif électronique selon une ou plusieurs des revendications 1 à 6, dans lequel la cathode (9) comprend un matériau qui est sélectionné parmi le groupe des métaux nobles, de préférence le Pt ou le Pd, de façon très préférable, la cathode (9) se présente sous la forme d'un maillage métallique perméable aux gaz.

8. Dispositif électronique selon une ou plusieurs des revendications 1 à 7, dans lequel le matériau électroniquement actif (2) est un matériau sensible à l'oxygène.

9. Dispositif électronique selon une ou plusieurs des revendications 1 à 8, dans lequel le matériau électroniquement actif (2) est un matériau électronique organique ou un matériau qui contient au moins un point quantique.

10. Dispositif électronique selon la revendication 9, dans lequel le matériau électronique organique (2) est un matériau émetteur de lumière ou électroluminescent.

11. Utilisation d'une pompe à ions d'oxygène (8) pour enlever l'oxygène hors d'un dispositif électronique selon une ou plusieurs des revendications 1 à 10.

12. Dispositif électronique selon une ou plusieurs des revendications 1 à 10 ou utilisation selon la revendication 11, dans lequel ou laquelle le dispositif électronique est sélectionné parmi le groupe qui est constitué par les dispositifs électroluminescents organiques ou organiques polymériques (OLED, PLED), les transistors à effet de champ organiques (OFET), les circuits intégrés organiques (OIC), les transistors à film mince organiques (OTFT), les transistors à émission de lumière ou électroluminescents organiques (OLET), les cellules solaires organiques (OSC), les détecteurs optiques organiques, les diodes laser organiques (O-laser), les dispositifs à extinction de champ organiques (OFQD), les cellules électrochimiques à émission de lumière ou électroluminescentes (LEC), les dispositifs à émission de plasmons organiques et les éléments ou dispositifs photovoltaïques organiques (OPV), et les photorécepteurs organiques (OPC).
